# EUROPEAN PATENT APPLICATION

(11) **EP 0 626 775 A1**
(43) Date of publication of application: **30.11.1994**
(21) Application number: 93108311.7
(22) Date of filing: 22.05.1993
(51) Int. Cl.: H04N 1/00, H03J 7/06, H03J 1/00

(54) **Tuning system with a voltage synthesizer and a digital memory**

(71) Applicant: SELECO S.p.A., I-33170 Pordenone (IT)
(72) Inventor: Liverotti, Giorgio, I-33170 Pordenone (PN) (IT)
(74) Representative: Dini, Roberto, Dr. Ing.

(57) **Abstract**

The present invention refers to an improved voltage synthesis tuning system with digital memory, in particular for a television transmissions receiver, wherein a plurality of digital codes, each respectively identifying a television channel, are memorised in a digital tuning memory, to a corresponding plurality of addresses, with an automatic tuning circuit, and with means for modifying the respective digital code, in the presence of frequency drift phenomenons, exceeding the pull-in range of such automatic tuning circuit; the main characteristic of the invention consists in that the system searches the television station modifying the digital tuning code and simultaneously verifying the presence of a station identification signal; and that the exact tuning is obtained verifying a high slope signal coming from the automatic tuning circuit.

## Description

The present invention refers to an improved voltage synthesis tuning system with digital memory, in particular for a television transmissions receiver, wherein a plurality of digital codes, each respectively identifying a television channel, are memorised in a digital tuning memory, to a corresponding plurality of addresses, with an automatic tuning circuit, and with means for modifying the respective digital code, in the presence of frequency drift phenomenons, exceeding the pull-in range of such automatic tuning circuit.

Television transmissions receivers utilising voltage synthesis tuning systems are known, for example as that described in the English patent N. 1 520 849.

In such patent a system wherein a plurality of digital codes is described, each respectively identifying a television channel, memorised in a digital tuning memory, to a corresponding plurality of addresses.

At the moment of carrying out the tuning, the digital code relative to the desired channel is read from the memory, is converted to an analogous value, and the corresponding voltage to such value is applied to the tuner, that is of the normal type having a controlled voltage oscillator (V.C.O).

It is known that voltage synthesis systems are subject to drift phenomenons, due to for example temperature variations, or to the ageing of components; such phenomenons cause the tuning to no longer be (in fact never be) exact.

For this reason generally such systems provide a so-called automatic tuning circuit (A.F.C.); however such circuits have to be sized based on a compromise; it is in fact known that the slope, or the precision, of the AFC circuit is inversely proportional to the pull-in range; as a result, for presenting an acceptable precision such circuits cannot have an excessively wide pull-in range; unfortunately drifts generally exceed such range, therefore it has been proposed to remedy such drawback. It is known, for example from English patent N. 1 518 712, to memorise a modified digital code, in place of the original, whenever a tuning discrepancy is revealed being greater than an established acceptable limit.

If however a channel is not selected for a long period of time, it may occur that, at the moment of the selection, the drift results in being greater than the pull-in range and the tuning results in being impossible.

For overcoming this drawback, the cited English patent N. 1 520 849 provides that, upon the act of the tuning operation, it is detected if found to be outside of the aforementioned pull-in range, and, in that case, a cyclic variation of the digital code is carried out, in order to vary the frequency and to be bring it within the range, and that the code correction is memorised. It is clear that all this requires a complex and delicate apparatus, and problems can arise in practice, with the result of embarrassing the user.

The aim of the present invention is to indicate a simple and effective procedure of management of a voltage synthesis system of the type previously described.

For allowing such aims the present invention refers to an improved voltage synthesis tuning system with digital memory, in particular for a television transmissions receiver, wherein a plurality of digital codes, each respectively identifying a television channel, are memorised in a digital tuning memory, to a corresponding plurality of addresses, with an automatic tuning circuit, and with means for modifying the respective digital code, in the presence of frequency drift phenomenons, exceeding the pull-in range of such automatic tuning circuit, characterised in that the system searches the television station modifying the digital tuning code and simultaneously verifying the presence of a station identification signal; and that the exact tuning is obtained verifying a high slope signal coming from the automatic tuning circuit.

Further aims and advantages of the present invention will result in being clear from the detailed description that follows and from the annexed drawings, supplied purely as an explanatory and non-limiting example, wherein:
figure 1 represents the paths of the frequency and of the automatic tuning tension (AFC) during the search phase of a station, in a tuning system according to the invention;
figure 2 represents the paths of the frequency and of the automatic tuning tension (AFC) during the recall phase of a station already memorised, in a tuning system according to the invention.

The voltage synthesis tuning system according to the invention is controlled by a micro-controller, with a D/A converter having the necessary resolution, for example with 14 bits; for tuning the television to a preselected channel the local oscillator of the 'tuner' must oscillate to the central frequency of the channel, incremented to the value of the intermediate frequency. This is obtained by loading the D/A converter of the micro-controller with the appropriate digital tuning code and selecting the band, establishing the relative commutation band lines. The voltage converted tuning code pilots the voltage controlled oscillator (VCO) of the 'tuner' and on the same 'tuner' acts upon the commutation band lines.

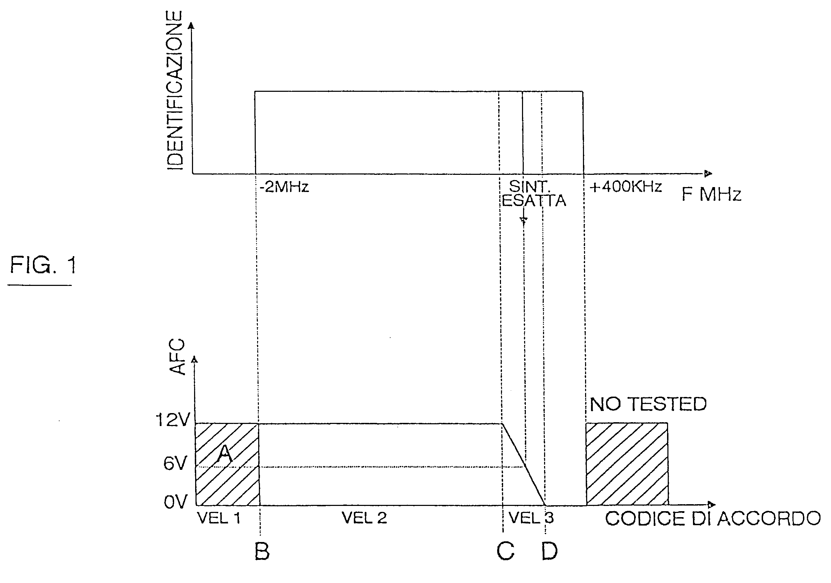

The tuning of a station by the system does not terminate as mentioned above, but is completed with a sophisticated control. The micro-controller in the search phase of stations (and memorisation of relative codes) increments the tuning code in stages such for obtaining in output of the voltage controlled oscillator (VCO) of the 'tuner' of frequency variations to the order of about 500 KHz (speed 1) for each single stage (note fig. 1, A); simultaneously the micro-controller tests the identification signal coming from the Intermediate Frequency integrated circuit, in order to detect the presence or not of a station. If the presence of a station is not detected, the micro-controller increments the tuning code by a further stage (always such so as to produce a frequency variation of about 500 KHz) and re-executes the test on the presence of the identification signal coming from the Intermediate Frequency integrated circuit, in order to detect the presence or not of a station. These operations are carried out by the micro-controller until the signal identification information signals the presence of a station.

In the presence of a station the micro-controller modifies the increment of the tuning code for obtaining a frequency variation of about 200 KHz (speed 2) with each stage (note fig. 1, B). From this moment, with each stage, the contemporary presence of the identification signal and of the signal is tested, coming from a A/D converter), able to discriminate the coming signal level from the automatic tuning circuit (AFC).

When the micro-controller detects for the first time the beginning of the descendant path (note fig. 1, C) of the automatic tuning curve (AFC), through reading the A/D converter, it memorises, in an auxiliary memory, the value of the effective tuning code in that moment and modifies the increment of the tuning code for obtaining a variation being as small as possible with each stage (about 50 KHz, speed 3), in order to obtain the maximum resolution.

From this moment, with each stage, the contemporary presence of the identification signal and of the signal is tested, coming from a A/D converter, in order to detect the point wherein the curve reaches a lower established value (note fig. 1, D). At this point the micro-controller executes the mathematical medium between the code agreement present and that previously memorised and memorises such medium value in the digital tuning memory, to the corresponding address to the station found; in this way the system will execute a tuning of the channel being as near as possible to the ideal.

As can be clearly seen in the drawings the pull-in range is very wide, and simultaneously the slope of the AFC device is very accentuated; in this way both a wide pull-in range (ensured by the digital search system) and a high tuning precision (ensured from slope of the AFC) are obtained.

In the recall phase of a station the micro-controller must recall from its memory (obviously of non volatile type) the tuning code previously memorised, for the D/A converter, the relative information to the band and, eventually, a relative code to the transmission standard, in the case of a multi-standard receiver. However the tuning of a station by the micro-controller is not terminated as mentioned above; in fact it is completed by sophisticated control operations.

Due to tuning drifts caused by variations of temperature (both of the environment and of that inside the receiver itself), the tuning of the relative station may require voltage agreement variations (and therefore a digital code) being more or less large.

For over coming this the micro-controller carries out corrections on the previously memorised tuning code, as will now be described; it is however specified that, in such phase, the corrected tuning code is not memorised.

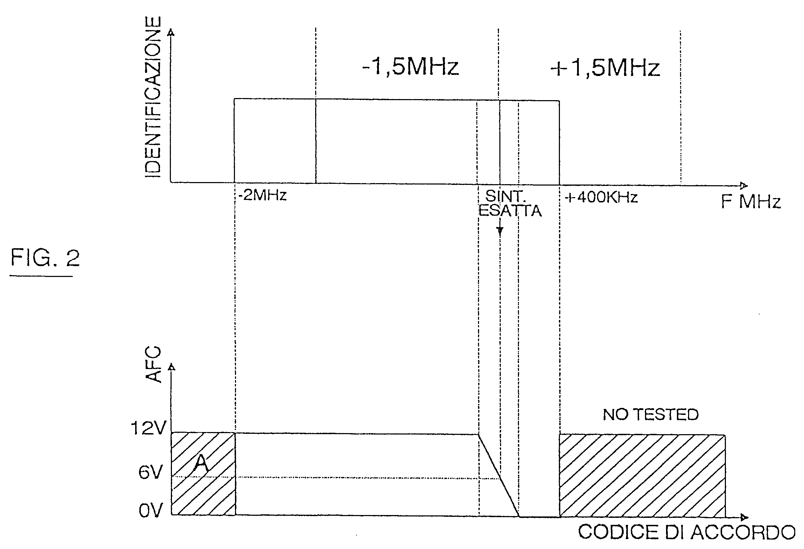

It permits that the maximum frequency drift has been detected in more or less 1,5 MHz. With each station change the micro-controller, after having loaded relative tuning data to the new chosen station, tests the presence of the identification signal coming from the intermediate frequency integrated circuit, in order to detect the presence or not of a station. If the presence of a station is not detected, the micro-controller understands that drifts have been verified in a negative sense (in fact if drifts occur in a positive sense the station is always present, for the characteristics of the television signal) and that it is necessary to decrease the agreement frequency respect that present (note fig. 2).

The micro-controller therefore decreases the tuning code by a stage (equal to about 500 KHz in frequency) and carries out again the test on the identification signal; in the negative case the decrement and successive test are repeated a maximum of 4 times (for about 2 MHz total), unless the presence of a stations detected before.

In the presence of a station the micro-controller modifies the variation stage of the tuning code for obtaining a frequency variation of about 200 KHz per stage. With each stage the presence of the identification signal and of the coming signal from the A/D converter, indicative of the voltage level coming from the automatic tuning circuit (AFC).

Analysing the information received from the A/D converter the micro-controller is able to establish whether the current tuning code involves a positive or negative de-tuning (note fig. 2; in the case used as an example the exact tuning has an output of 6 volt from circuit AFC). As a result, in vicinity of the correct tuning, the micro-controller modifies the tuning code for obtaining a frequency variation of about 50 KHz in the opposite respect the de-tuning; with successive stages the system is thus brought to correct tuning, eliminating the drift effect.

In this phase it assumes the correct tuning to be that corresponding to a signal of 6 volts in output from automatic tuning.

Apart from this, the micro-controller also provides for correcting drifts of a minor entity, slower over time (for example those of eventual antenna converters). In fact the micro-controller, also during the normal functioning of the receiver, tests the identification signal, coming from the intermediate frequency integrated circuit, for sensing the presence of a station; if the presence of a station is not detected, no correction is carried out; in presence of a station the micro-controller tests the signal coming from the A/D converter, indicative of the voltage level coming from the automatic tuning circuit (AFC); if the micro-controller detects a de-tuning, be it negative or positive, it provides for modifying the tuning code as a consequence, for obtaining a variation of 50 KHz in the opposite sense of the detected detuning.

This constant control over time ascertains that the slow detunings are eliminated, allowing a vision being always optimal and a perfect decoding of an eventual teletext transmission, very sensitive to perfect tuning, as is known.

On the other hand also in this control during normal functioning the eventual correct tuning code is not memorised in the digital tuning memory.

The characteristics of the voltage synthesis tuning system described are clear from the description of the example.

From the given description the advantages of the system subject of the present invention are also clear.

In particular they consist in that:
- the system ensures a very wide pull-in range, and simultaneously, a high tuning precision;
- the perfect correction of drifts is guaranteed, at any moment of the reception;
- drifts of more or less 2 MHz are made on the act of recalling a station; in this way, also after a long period of non use, the tuning is guaranteed;
- a tuning performance being practically perfect is obtained, with simple means; in fact a micro-controller is already present in the totality of modern receivers; required additional circuits are of a limited number and of modest cost.

It is clear that the described system is more effective and also however more simple, and therefore more reliable than those known till now; It is also clear that numerous variations are possible by the skilled-man, to the system described by way of example, without departing from the novelty principles inherent in the invention.

## Claims

1. Improved voltage synthesis tuning system with digital memory, in particular for a television transmissions receiver, wherein a plurality of digital codes, each respectively identifying a television channel, are memorised in a digital tuning memory, to a corresponding plurality of addresses, with an automatic tuning circuit, and with means for modifying the respective digital code, in the presence of frequency drift phenomenons, exceeding the pull-in range of such automatic tuning circuit, characterised in that the system searches the television station modifying the digital tuning code and simultaneously verifying the presence of a station identification signal; and that the exact tuning is obtained verifying a high slope signal (AFC) coming from the automatic tuning circuit.

2. Improved voltage synthesis tuning system, according to claim 1, characterised in that the search takes place at different and decreasing speeds depending on the combination of signals received from identification circuit and from the automatic tuning circuit; a first speed when the identification signal is absent (zone A); a second speed lower than the first when the identification signal is present and the signal of the automatic tuning circuit is found in the non-pending path (zone B-C); a third speed lower than the second when the signal of the automatic tuning circuit is found in the pending path (zone C-D).

3. Improved voltage synthesis tuning system, according to claim 2, characterised in that such first speed is about 500 KHz per stage; such second speed is about 200 KHz per stage; such third speed is about 50 KHz per stage.

4. Improved voltage synthesis tuning system, according to claim 2, characterised in that when the beginning of the pending path (C-D) of the automatic tuning curve (AFC) is detected, the value of the effective digital tuning code in that moment is memorised.

5. Improved voltage synthesis tuning system, according to claim 4, characterised in that when the end of the pending path (C-D) of the automatic tuning curve (AFC) is detected, the mathematical medium between the present value of the digital tuning code and the value previously memorised is executed, in order to obtain a code value being as close as possible to the ideal, and that said code value is memorised in said digital tuning memory, to the address corresponding to the station found.

6. Improved voltage synthesis tuning system, according to claim 2, characterised in that, in the tuning phase of a station already previously memorised, if the presence of a station is not detected, with the code previously memorised, said code utilising said first speed is decreased, for an established maximum number (4) of times.

7. Improved voltage synthesis tuning system, according to claim 6, characterised in that if, following one or more of said decrements, the presence of a station is detected, the search speed of said second value is reduced; and that successively, as soon as the beginning of the pending path (C-D) of the automatic tuning curve (AFC) is detected, the speed of said third value is commuted, for the tuning search.

8. Improved voltage synthesis tuning system, according to claim 6, characterised in that if, following one or more of said decrements, the presence of a station is detected, the search speed of said second value is reduced; and that successively, as soon as the beginning of the pending path (C-D) of the automatic tuning curve (AFC) is detected, the speed to said third value is commuted, and finally, when it is detected that the voltage coming from the automatic tuning corresponds to half of the maximum value, the procedure is interrupted.

9. Improved voltage synthesis tuning system, according to claim 2 or 6, characterised in that also during the normal functioning of the receiver, the identification signal is controlled; if the presence of a station is not detected, no correction is carried out; in the presence of a station, the signal coming from the automatic tuning circuit (AFC) is controlled; if a de-tuning is detected, negative or positive, it is arranged to modify the code of agreement in consequence, utilising said third speed, for obtaining a variation in the opposite sense of the detected de-tuning.

10. Improved voltage synthesis tuning system, according to one or more of claims 7, 8 and 9, characterised in that, in the tuning phase of a station already previously memorised, the tuning code, eventually modified in the course of the control procedure of the tuning, is not memorised in the digital tuning memory, in which remains memorised the value of the tuning code found during the search phase of the station.

11. Improved voltage synthesis tuning system with digital memory, in particular for a television transmissions receiver, wherein a plurality of digital codes, each respectively identifying a television channel, are memorised in a digital tuning memory, to a corresponding plurality of addresses, with an automatic tuning circuit, and with means for modifying the respective digital code, in the presence of frequency drift phenomenons, characterised in that the system searches the television station modifying the digital tuning code and simultaneously verifying the presence of a station identification signal; and that the exact tuning is obtained, always by means of modification of the digital tuning code, based on the information obtained with the assistance of a signal (AFC) coming from automatic tuning circuit.

12. Improved voltage synthesis tuning system with digital memory, in particular for a television transmissions receiver, wherein a plurality of digital codes, each respectively identifying a television channel, are memorised in a digital tuning memory, to a corresponding plurality of addresses, with an automatic tuning circuit, and with means for modifying the respective digital code, in the presence of frequency drift phenomenons, characterised in that, in the recall phase of a memorised station, and of absence of a station identification signal, the system searches the television station modifying the digital tuning code, in order to decrease the agreement frequency and simultaneously verifying the presence of the station identification signal.
